# EUROPÄISCHE PATENTSCHRIFT

(11) **EP 0 379 865 B1**
(45) Veröffentlichungstag und Bekanntmachung des Hinweises auf die Patenterteilung: **28.12.1994**
(21) Anmeldenummer: 90100170.1
(22) Anmeldetag: 04.01.1990
(51) Int. Cl.: H01J 37/30, H01J 37/28

(54) **Verfahren zur Untersuchung einer Probe in einem Korpuskularstrahlgerät**
Specimen examination method for a corpuscular-beam apparatus
Procédé d'examen d'un échantillon dans un appareil à faisceau corpusculaire

(30) Priorität: 25.01.1989 DE 3902165
(43) Veröffentlichungstag der Anmeldung: 01.08.1990
(73) Patentinhaber: ICT Integrated Circuit Testing Gesellschaft für Halbleiterprüftechnik mbH, D-85551 Kirchheim (DE)
(72) Erfinder: Brunner, Matthias, Dr.-Dipl.-Phys., D-8011 Kirchheim (DE); Lischke, Burkhard, Dr.-Dipl.-Ing., D-8000 München 82 (DE)
(74) Vertreter: Tetzner, Volkmar, Dr.-Ing. Dr. jur.

(56) Entgegenhaltungen:
- EP-A- 0 191 440
- GB-A- 2 168 839
- GB-A- 2 183 898
- US-A- 4 769 543
- PATENT ABSTRACTS OF JAPAN, Band 9, Nr. 251 (E-348)[1974], 8. Oktober 1985;& JP-A-60 100 349
- PROCEEDINGS OF THE EUROPEAN CONGRESS ON ELECTRON MICROSCOPY, Manchester,September 1972, Band 5, Institute of Physics, London, GB; V.G. GALSTYAN et al.:"The immersion objective as a secondary electron collector in the scanningelectron microscope"

## Beschreibung

Die Erfindung bezieht sich auf ein Verfahren zur Untersuchung einer Probe in einem Korpuskularstrahlgerät nach dem Oberbegriff des Patentanspruchs 1.

In allen Bereichen der Entwicklung und Fertigung mikro- und optoelektronischer Bauelemente besteht ein steigender Bedarf an abbildenden Verfahren, um Mikrometerstrukturen visuell beurteilen, Abweichungen von Sollmustern feststellen und die durch Partikelbelegung erzeugten Defekte auf Masken und Wafern lokalisieren zu können. Aufgrund der geringen Tiefenschärfe sind lichtoptische Verfahren für die Defekterkennung in Submikrometerstrukturen nur noch begrenzt einsetzbar. Es wurden deshalb elektronenoptische Abbildungsverfahren entwickelt, bei denen man das zu untersuchende Objekt mit einem fokussierten Elektronenstrahl abtastet und den durch Topographie-, Material- oder Potentialkontrast modulierten Sekundärelektronenstrom in einem Detektor nachweist. Da das für eine sichere Defekterkennung notwendige Signal-Rausch-Verhältnis die Abtastgeschwindigkeit begrenzt, erlauben diese Verfahren nur einen geringen Durchsatz an inspizierten Objekten.

Der Erfindung liegt die Aufgabe zugrunde, ein Verfahren der eingangs genannten Art anzugeben, das einen hohen Durchsatz an inspizierten Objekten gewährleistet. Diese Aufgabe wird erfindungsgemäß durch ein Verfahren nach Patentanspruch 1 gelöst.

Der mit der Erfindung erzielbare Vorteil besteht insbesondere darin, daß man die durch Partikelbelegung erzeugten Defekte auf Masken und Wafern sehr schnell lokalisieren kann, wobei die Auflösung der bekannter teilchenoptischer Abbildungsverfahren entspricht.

Die Unteransprüche betreffen vorteilhafte Weiterbildungen der Erfindung, die im folgenden anhand der Zeichnungen näher erläutert wird. Hierbei zeigen:
Fig. 1 und 2 Vorrichtungen zur Durchführung des erfindungsgemäßen Verfahrens
Fig. 3 und 4 Vorrichtungen zur Erzeugung einer linienförmigen Elektronensonde

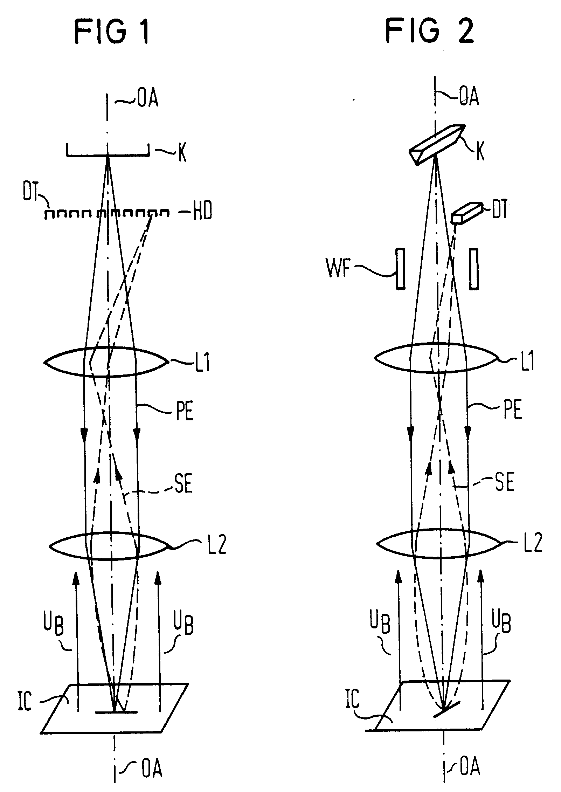

Zur Durchführung des erfindungsgemäßen Verfahrens eignet sich insbesondere das in Fig. 1 schematisch dargestellte Elektronenstrahlmeßgerät. Es besteht im wesentlichen aus einem eine schneidenförmige Kathode K aufweisenden Strahlerzeuger, einer Elektronenoptik zur Fokussierung der von der Kathode K emittierten und in Richtung einer Anode beschleunigten Primärelektronen PE auf die zu untersuchende Probe IC und einem Detektor DT zum Nachweis der auf der Probe IC ausgelösten Sekundärelektronen SE. In dem gezeigten Ausführungsbeispiel ist eine die Linsen L1 und L2 umfassende Elektronenoptik vorgesehen, die die aufgrund der Kathodengeometrie linienförmige Primärelektronenquelle verkleinert auf die unmittelbar unterhalb der Linse L2 angeordnete Probe IC abbildet. Als Objektivlinse L2 dient eine Immersionslinse, an deren magnetisches Feld sich ein die Primärelektronen PE abbremsendes, die ausgelösten Sekundärelektronen SE entgegen der Primärstrahlrichtung beschleunigendes elektrisches Feld anschließt. Die Stärke des im Raumbereich zwischen der Linse L2 und der Probe IC aufgebauten elektrischen Verzögerungs- bzw. Beschleunigungsfeldes (symbolisiert durch die mit U_{B} bezeichneten Pfeile) ist hierbei so bemessen, daß die Elektronenoptik ein vergrößertes Bild der aufgrund der Strahlfleckgeometrie ebenfalls linienförmigen Sekundärelektronenquelle auf dem im Strahlengang oberhalb der Linse L1 angeordneten Detektor DT erzeugt (in Fig. 1 ist nur der Strahlengang für die an einem außerhalb der optischen Achse OA liegenden Punkt ausgelösten Sekundärelektronen SE dargestellt). Als Detektor DT kommt insbesondere eine linienförmige Anordnung von Halbleiterdioden in betracht, wobei jedem Detektorelement HD ein Linienelement des vom Primärstrahl jeweils ausgeleuchteten Oberflächenbereichs zugeordnet ist. Da man sehr viele Objektpunkte gleichzeitig mit dem Primärstrahl abtastet und die ausgelösten Sekundärelektronen SE in den den Objektpunkten jeweils zugeordneten Detektorelementen HD nachweist, reduziert sich die Zeit zur Untersuchung der Probe IC erheblich. Eine großflächige Abtastung der Probenoberfläche wird hierbei durch Ablenkung des primären Elektronenstrahls und/oder durch mechanisches Verschieben der Probe IC bezüglich der optischen Achse OA erreicht.

Wie die Fig. 2 schematisch zeigt, kann man die im elektrischen Feld der Immersionslinse OL beschleunigten Sekundärelektronen SE auch in einem außerhalb der optischen Achse OA angeordneten Detektor DT nachweisen, wobei als Ablenkeinheit insbesondere ein den Primärstrahl nicht beeinflussendes Wien-Filter oder ein elektrisches bzw. magnetisches Multipolelement WF Verwendung findet.

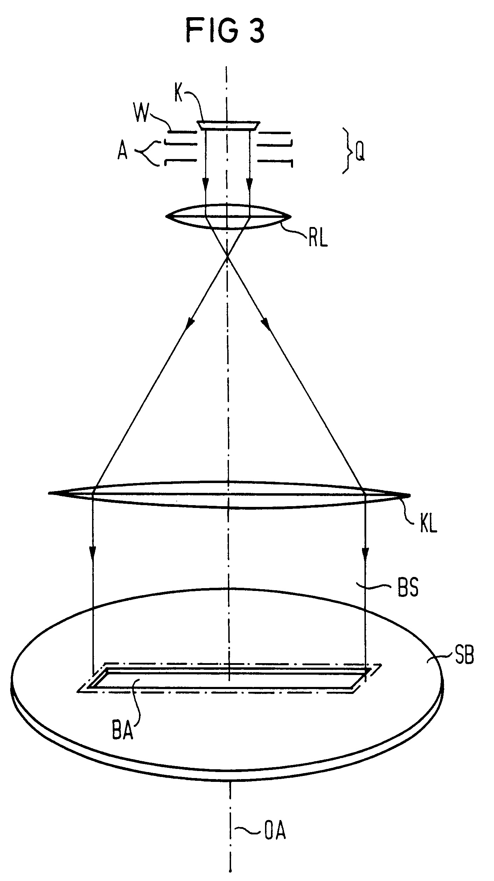

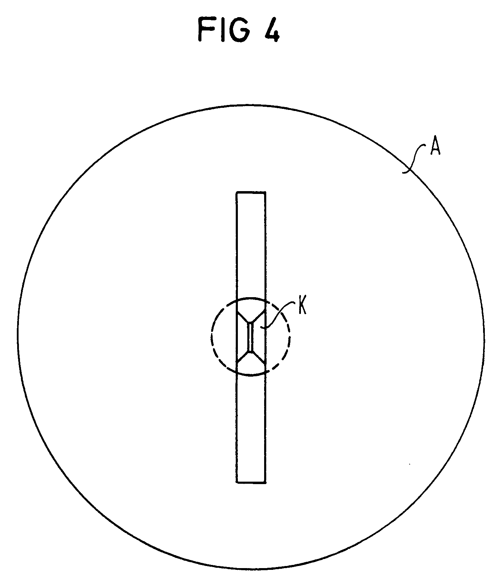

Zur Abtastung der Probe IC verwendet das erfindungsgemäße Verfahren eine Elektronensonde mit einem Strahlquerschnitt, dessen in einer ersten Richtung gemessene Ausdehnung sehr viel größer ist als in einer dazu orthogonalen Richtung (lₓ: l_{y} > 10:1). Wie eingangs erwähnt, bedient man sich bei der Erzeugung einer solchen Elektronensonde der verkleinernden elektronenoptischen Abbildung eine Linienquelle, die beispielsweise auch aus einer Vielzahl linienförmig angeordneter Einzelquellen bestehen kann. Es ist selbstverständlich auch möglich, eine Schlitzblende mit einem runden oder bandförmigen Elektronenstrahl auszuleuchten und die Blendenöffnung verkleinert auf die Probe IC abzubilden. Wie die Fig. 3 zeigt, umfaßt die Elektronenoptik zur Ausleuchtung der eine rechteckförmige Durchtrittsöffnung BA aufweisende Blende SB beispielsweise eine Rundlinse RL und eine magnetische Kondensorlinse KL, die unmittelbar unterhalb des Elektronenstrahlerzeugers Q angeordnet sind. Dieser besteht vorzugsweise aus einer linienförmigen Kathode K, insbesondere einem LaB6-Schneidenemitter mit abgeflachter Spitze, einer im Bereich der Kathodenspitze angeordneten Schlitzblende W sowie einer Doppelanode A, deren Elektroden ebenfalls als Schlitzblenden ausgebildet sind (s. die den Strahlenerzeuger Q in Draufsicht zeigende Fig. 4).

Die die Probe IC abtastende Elektronensonde setzt sich aus einer Vielzahl von Teilstrahlen zusammen, falls die Blende SB eine linienförmige Anordnung von quadratischen Durchtrittsöffnungen aufweist. Hierbei ist es von Vorteil, jeden der Teilstrahlen aus einer eigenen Quelle zu speisen. Als Elektronenquellen kommen beispielsweise die aus J. Vac. Sci. Technol. A5 (4), 1987, Seite 1544 bis 1548 bekannten Silizium-Kaltkathoden, Photokathoden (Appl. Phys. Lett. 51.2, 1987, Seite 145 bis 147), Lab6-Einkristall-Schneidenemitter (US-A-4 724 328) und die in SRI International Technical Note 2, November 1984 beschriebenen Feldemissionskathoden in betracht.

Die Erfindung ist selbstverständlich nicht auf die beschriebenen Ausführungsbeispiele beschränkt. So ist es ohne weiteres möglich, anstelle von Sekundärelektronen auch rückgestreute Elektronen im Detektor nachzuweisen. Diese werden aufgrund der Strahlfleckgeometrie ebenfalls in einem linienförmigen Bereich ausgelöst.

In dem beschriebenen Elektronenstrahlmeßgerät können weitere Linsen vorgesehen sein, um die notwendige Verkleinerung der Primärelektronenquelle bzw. Vergrößerung der Sekundärteilchenquelle zu erzielen.

Es ist selbstverständlich auch möglich, die elektronenoptischen Strahlengänge von Primär- und Sekundärteilchen zu trennen und für jeden Strahlengang abbildende Elemente vorzusehen.

## Patentansprüche

1. Verfahren zur Untersuchung einer Probe (IC) in einem Korpuskularstrahlgerät, bei dem die Probe (IC) mit einer Teilchensonde (PE) bestrahlt wird und bei dem die von der Teilchensonde (PE) ausgelösten Sekundärteilchen (SE) nachgewiesen werden,
**dadurch gekennzeichnet**, daß eine Teilchensonde (PE) mit einem linienförmigen Querschnitt erzeugt und auf die Probe (IC) gerichtet wird und daß eine dadurch erzeugte linienförmige Sekundärteilchenquelle auf einen oberhalb einer Objektivlinse (OL) des Korpuskularstrahlgeräts angeordneten Detektor (DT) abgebildet wird.

2. Verfahren nach Anspruch 1,
**dadurch gekennzeichnet**, daß die Sekundärteilchenquelle auf einen linienförmigen, aus einer Vielzahl von teilchenempfindlichen Elementen (HD) bestehenden Detektor (DT) abgebildet wird.

3. Verfahren nach einem der Ansprüche 1 oder 2,
**dadurch gekennzeichnet**, daß die Sekundärteilchen (SE) oberhalb der Objektivlinse (OL) abgelenkt und in dem außerhalb einer optischen Achse (OA) des Korpuskularstrahlgeräts angeordneten Detektor (DT) nachgewiesen werden.

4. Verfahren nach Anspruch 3,
**dadurch gekennzeichnet**, daß die Sekundärteilchen (SE) unter Verwendung eines Wien-Filters (WF) abgelenkt werden.

5. Verfahren nach Anspruch 3,
**dadurch gekennzeichnet**,
daß die Sekundärteilchen (SE) unter Verwendung eines elektrischen oder magnetischen Multipolelementes abgelenkt werden.

6. Verfahren nach einem der Ansprüche 1 bis 5,
**dadurch gekennzeichnet**, daß die Sekundärteilchenquelle unter Verwendung einer als Objektivlinse dienenden Immersionslinse (OL) abgebildet wird.

7. Verfahren nach einem der Ansprüche 1 bis 6,
**dadurch gekennzeichnet**, daß eine aus einer Mehrzahl von Teilstrahlen bestehenden Teilchensonde (PE) erzeugt wird.

8. Verfahren nach Anspruch 7,
**dadurch gekennzeichnet**, daß die Teilstrahlen jeweils aus einer Teilchenquelle gespeist werden und daß die Teilchenquellen linienförmig angeordnet werden.

9. Verfahren nach einem der Ansprüche 1 bis 6,
**dadurch gekennzeichnet**, daß die Teilchensonde (PE) durch Abbildung einer von einem Primärstrahl (BS) ausgeleuchteten Blendenöffnung (BA) erzeugt wird.

10. Verfahren nach einem der Ansprüche 1 bis 9,
**dadurch gekennzeichnet**, daß die Teilchensonde (PE) unter Verwendung einer eine schneidenförmige Kathode (K) aufweisenden Teilchenquelle (Q) erzeugt wird.

11. Verfahren nach einem der Ansprüche 1 bis 10,
**dadurch gekennzeichnet**, daß die Probe (IC) durch Ablenkung der Teilchensonde (PE) flächenhaft abgetastet wird.

12. Verfahren nach einem der Ansprüche 1 bis 11,
**dadurch gekennzeichnet**, daß die Probe (IC) bezüglich der Teilchensonde (PE) verschoben wird.

## Claims

1. Method for examining a specimen (IC) in a corpuscular beam apparatus, in which the specimen (IC) is irradiated by a particle probe (PE) and in which the secondary particles (SE) released by the particle probe (PE) are detected, characterized in that a particle probe (PE) with a linear cross-section is generated and is directed onto the specimen (IC), and in that a linear secondary particle source generated thereby is imaged onto a detector (DT) disposed above an objective lens (OL) of the corpuscular beam apparatus.

2. Method according to Claim 1, characterized in that the secondary particle source is imaged onto a linear detector (DT) comprising a multiplicity of particle-sensitive elements (HD).

3. Method according to one of Claims 1 or 2, characterized in that the secondary particles (SE) are deflected above the objective lens (OL) and are detected in the detector (DT) disposed outside an optical axis (OA) of the corpuscular beam apparatus.

4. Method according to Claim 3, characterized in that the secondary particles (SE) are deflected using a Wien filter (WF).

5. Method according to Claim 3, characterized in that the secondary particles (SE) are deflected using an electric or magnetic multipole element.

6. Method according to one of Claims 1 to 5, characterized in that the secondary particle source is imaged using an immersion lens (OL) serving as objective lens.

7. Method according to one of Claims 1 to 6, characterized in that a particle probe (PE) comprising a plurality of partial beams is generated.

8. Method according to Claim 7, characterized in that the partial beams are fed in each instance from a particle source, and in that the particle sources are disposed linearly.

9. Method according to one of Claims 1 to 6, characterized in that the particle probe (PE) is generated by imaging a diaphragm aperture (BA) illuminated by a primary beam (BS).

10. Method according to one of Claims 1 to 9, characterized in that the particle probe (PE) is generated using a particle source (Q) exhibiting a knife-edge-shaped cathode (K).

11. Method according to one of Claims 1 to 10, characterized in that the specimen (IC) is surface-scanned by deflection of the particle probe (PE).

12. Method according to one of Claims 1 to 11, characterized in that the specimen (IC) is displaced with respect to the particle probe (PE).

## Revendications

1. Procédé pour examiner un échantillon (IC) dans un appareil à faisceau corpusculaire, selon lequel l'échantillon (IC) est irradié par une sonde particulaire (PE) et selon lequel des particules secondaires (SE) produites par la sonde particulaire (PE) sont détectées, caractérisé par le fait qu'on forme une sonde particulaire (PE) possédant une section transversale linéaire et qu'on la dirige sur l'échantillon (IC), et qu'on forme l'image d'une source de particules secondaires de forme linéaire, ainsi produite, sur un détecteur (DT) disposé au-dessus d'une lentille d'objectif (OL) de l'appareil à faisceau corpusculaire.

2. Procédé suivant la revendication 1, caractérisé par le fait qu'on forme l'image de la source de particules secondaires sur un détecteur de forme linéaire (DT), qui est constitué par une multiplicité d'éléments (HD) sensibles aux particules.

3. Procédé suivant l'une des revendications 1 ou 2, caractérisé par le fait qu'on dévie les particules secondaires (SE) au-dessus de la lentille d'objectif (OL) et qu'on détecte les particules secondaires dans le détecteur (DT) disposé en dehors d'un axe optique (OA) de l'appareil à faisceau corpusculaire.

4. Procédé suivant la revendication 3, caractérisé par le fait que les particules secondaires (SE) sont déviées moyennant l'utilisation d'un filtre de Wien (WF).

5. Procédé suivant la revendication 3, caractérisé par le fait que les particules secondaires (SE) sont dévies moyennant l'utilisation d'un élément multipolaire électrique ou magnétique.

6. Procédé suivant l'une des revendications 1 à 5, caractérisé par le fait qu'on forme l'image de la source de particules secondaires moyennant l'utilisation d'une lentille à immersion (OL) utilisée comme lentille d'objectif.

7. Procédé suivant l'une des revendications 1 à 6, caractérisé par le fait qu'on forme une sonde particulaire (PE) constituée par une multiplicité de faisceaux partiels.

8. Procédé suivant la revendication 7, caractérisé par le fait que les faisceaux partiels sont prévus respectivement à partir d'une source de particules et que les sources de particules sont disposées suivant une disposition linéaire.

9. Procédé suivant l'une des revendications 1 à 6, caractérisé par le fait qu'on forme la sonde particulaire (PE) par formation de l'image d'une ouverture de diaphragme (BA) éclairée par un faisceau primaire (BS).

10. Procédé suivant l'une des revendications 1 à 9, caractérisé par le fait qu'on forme la sonde particulaire (PE) en utilisant une source de particules (Q) possédant une cathode en forme de couteau (K).

11. Procédé suivant l'une des revendications 1 à 10, caractérisé par le fait qu'on explore l'échantillon (IC) sur une certaine surface, par déviation de la sonde particulaire (PE).

12. Procédé suivant l'une des revendications 1 à 11, caractérisé par le fait qu'on déplace l'échantillon (IC) par rapport à la sonde particulaire (PE).
